(19) **Europäisches Patentamt / European Patent Office / Office européen des brevets**

(11) **EP 1 434 099 B1**

(12) **EUROPEAN PATENT SPECIFICATION**

(45) Date of publication and mention
of the grant of the patent:
**02.07.2008 Bulletin 2008/27**

(51) Int Cl.:
*G03F 7/20* (2006.01)   *G03F 1/14* (2006.01)

(21) Application number: **03257415.4**

(22) Date of filing: **25.11.2003**

(54) **Device manufacturing method**

Verfahren zur Herstellung einer Vorrichtung

Méthode de fabrication d'un dispositif

(84) Designated Contracting States:
**DE FR GB IT NL**

(30) Priority: **28.11.2002 EP 02258208**

(43) Date of publication of application:
**30.06.2004 Bulletin 2004/27**

(73) Proprietor: **ASML Netherlands B.V.**
**5504 DR Veldhoven (NL)**

(72) Inventors:
• **Lowisch, Martin**
**73447 Oberkochen (DE)**
• **Dierichs, Marcel Mathijs Theodore Marie**
**5914 WR Venlo (NL)**
• **Van Ingen Schenau, Koen**
**5612 HB Eindhoven (NL)**
• **Van Der Laan, Hans**
**5501 CL Veldhoven (NL)**
• **Leenders, Martinus Hendrikus Antonius**
**3039 ER Rotterdam (NL)**
• **Mcgoo, Elaine**
**5508 VC Veldhoven (NL)**

• **Mickan, Uwe**
**5508 AJ Veldhoven (NL)**

(74) Representative: **Leeming, John Gerard**
**J.A. Kemp & Co.**
**14 South Square**
**Gray's Inn**
**London WC1R 5JJ (GB)**

(56) References cited:
EP-A- 1 251 402     EP-A- 1 271 247
US-A- 5 789 734     US-A- 6 078 380
US-A- 6 115 108

• CHEN H L ET AL: "Simulation on a new reflection type attenuated phase shifting mask for extreme ultraviolet lithography" PROCEEDINGS OF THE SPIE, SPIE, BELLINGHAM, VA, US, vol. 3676, no. 1-2, 15 March 1999 (1999-03-15), pages 578-586, XP002230586 ISSN: 0277-786X
• OTAKI K.: "Asymmetric Properties of the Aerial Image in Extreme Ultraviolet Lithography" JAPANESE JOURNAL OF APPLIED PHYSICS, vol. 39, no. 12B, part 1, 1 December 2000 (2000-12-01), pages 6819-6826, XP002256405

**EP 1 434 099 B1**

## Description

The present invention relates to a device manufacturing method using a lithographic apparatus and to computer programs for use in controlling lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

To enable imaging of smaller features than is possible with current lithographic projection apparatus, it is proposed to use extreme ultraviolet radiation (EUV), e.g. with a wavelength of 13.5nm, as the exposure radiation. Such radiation is strongly absorbed by almost all known materials and so it is necessary to use a reflective mask. However, making a reflective mask for EUV presents its own problems and to achieve an acceptable reflectance, the mask must be formed as a distributed Bragg reflector formed by a multilayer of 40 or more layer pairs of, for example, (Mo/Si) or (Mo/Be). The mask pattern is then formed by an overlying patterned absorber layer such as Tantalum (Ta) or Chrome (Cr). The multilayer and absorber layer must be relatively thick, many tens of wavelengths, and this, coupled with the necessity to illuminate the mask obliquely, introduces various errors in the projected image, as compared to an ideal, thin binary mask.

These errors are discussed in various publications. B. S. Bollepalli and F. Cerrina, On the Computation of Reflected Images from Extreme Ultra Violet Masks, SPIE Conference on Emerging Lithographic Technologies III, Santa Clara, CA, SPIE Volume 3676, 587-597 (March 1999) describes variation of line widths and pattern shifts with angle of incidence of isolated structures and proposes correction by a suitable mask bias. C. G. Kzautschik, M. Ito, I. Nishiyama, and K. Otaki, Impact of the EUV mask phase response on the asymmetry of Bossung curves as predicted by rigorous EUV mask simulations, SPIE Conference on Emerging Lithographic Technologies V, Santa Clara, CA, SPIE Volume 4343 (March 2001) describes asymmetry of the Bossung curve through focus for isolated structures and indicates that different illumination angles experienced by horizontal and vertical lines causes an additional horizontal to vertical CD bias through focus. Again, it is proposed to compensate for these effects through mask-sizing schemes. K Otaki, Asymmetric properties of the Aerial Image in Extreme Ultraviolet Lithography, Jpn. J. Appl. Phys. Vol 39 (2000) pp b819-6826, describes the influence of asymmetric diffraction when a thick mask is asymmetrically illuminated and notes the asymmetry in the aerial image.

EP-1 251 402-A discloses the idea of deliberately introducing aberrations into a projection lens to compensate for other aberrations already present so as to minimize a merit function. Also disclosed is to compensate for Bossung tilt deriving from deviations from the correct 180° phase shift in a phase-shift mask (PSM)

However, the solutions proposed in the prior art do not provide complete solutions and cannot compensate for all mask-induced imaging artifacts.

It is an object of the present invention to provide a device manufacturing method using a reflective mask illuminated at an angle to the normal in which improved imaging is obtained.

According to an aspect of the invention, there is provided a device manufacturing method as defined in appended claim 1.

In the method of the invention, it is possible to compensate for best focus shift effects due to a reflective mask with a thick absorber and oblique illumination in such a way that best focus shift differences between dense and isolated lines, and between horizontal and vertical lines, can be reduced. A thick absorber for use with EUV radiation may, for example, have a thickness of 50-100nm or more. The invention uses any available "knobs" in the projection system to effect wavefront or phase manipulation to correct any correctables in the image shape. This assists in bringing process windows for different features closer together. It is also possible to use iso-focal tilt as the metric for level of aberration input and reduce the differences between different structure types. The choice of metric is important as improvement in isofocal tilt may worsen best focus shift performance, and vice versa.

The method of the present invention can also compensate for mask-induced image CD offset, which occurs as a function of mask angle of incidence (MAI), absorber thickness, feature type and NA/illumination settings. The dominant effect is a CD variation between features as a function of structural orientation, for example a horizontal-vertical (HV) bias varying across the image field. For contact holes, the mask will induce ellipticity variation across the image field.

Preferably, the low order system aberrations are Z5 astigmatism, Z9 spherical, and Z12 astigmatism (as defined below) or equivalent aberrations. Simulations of dense and semi-isolated structures, with and without aberrations, have provided sensitivity data for best focus (BF) shift and isofocal tilt (IFT). Optimized combinations of Zernikes Z5, Z9 and Z12 can compensate for, and reduce, best focus shifts and isofocal tilt to bring focus positions of dense, semi-isolated, horizontal and vertical lines of same critical dimension (CD) closer together. Thus, the possibility of overlapping process windows for imaging is enhanced. The effect of using such best focus shift compensation can also have a positive effect on isofocal tilt but this is feature dependent. Contact hole ellipticity variation across the image field can be compensated for using mostly Z5 astigmatism. HV bias variation can be compensated for in combination with best focus shift and iso-focal tilt using principally combinations of Z5, Z9 and Z12 aberrations.

A further problem that the invention may address is image displacement in the XY plane. Such displacements may occur as a function of mask angle of incidence, absorber thickness, feature type and NA/illumination settings and the displacements will be dependent on position in the image field. Whilst such effects may be compensated for in some cases by pre-distortion of the mask and by optical proximity corrections, these solutions tie the mask to use with a particular set of machine settings. A more flexible solution can be provided by the invention by controlling and/or introducing projection system aberrations, particularly Z2, Z3, and Z7 (as defined below).

A further aspect of the present invention provides a method and computer program for determining system aberrations to be effected in a projection system of a lithographic apparatus as defined in the appended claims.

Another aspect of the invention provides a computer program for controlling a lithographic projection apparatus to effect system aberrations in the projection system of the lithographic projection apparatus to optimize imaging of a reflective mask embodying a mask pattern in thick absorber as defined in the appended claims.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm).

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Examples of patterning means include masks and programmable mirror arrays. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate.

Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:

Figure 1 depicts a lithographic projection apparatus that may be used to carry out the method of the invention;
Figure 2 depicts a reflective multilayer mask that may be used in the method of the invention;
Figure 3 is a flow diagram of a method according to the invention;
Figure 4 is a diagram of a system for applying corrections determined in the method of the invention;
Figure 5 is a graph of best focus shift vs. pitch for 30nm lines on a bright field without any correction according to the invention being applied;
Figure 6 is a graph of isofocal tilt vs. pitch for 30nm lines on a bright field without any correction according to the invention being applied;
Figures 7 to 11 are graphs showing the effects on best focus shift and isofocal tilt with various degrees of correction according to the method of the invention;
Figures 12 to 15 are graphs of critical dimension vs. focus for various illumination conditions and degrees of correction;
Figure 16 is a graph of critical dimension uniformity vs. added focus range for illumination conditions and degrees of correction;
Figure 17 is a graph of image critical dimension as a function of mask angle of incidence and pitch;
Figure 18 is a graph of mask-induced critical dimension and horizontal-vertical bias as a function of position in the image field;
Figure 19 is a graph of image displacement as a function of mask angle of incidence and pitch; and
Figures 20 to 22 are diagrams used to explain the mask angle of incidence.

Lithographic Projection Apparatus

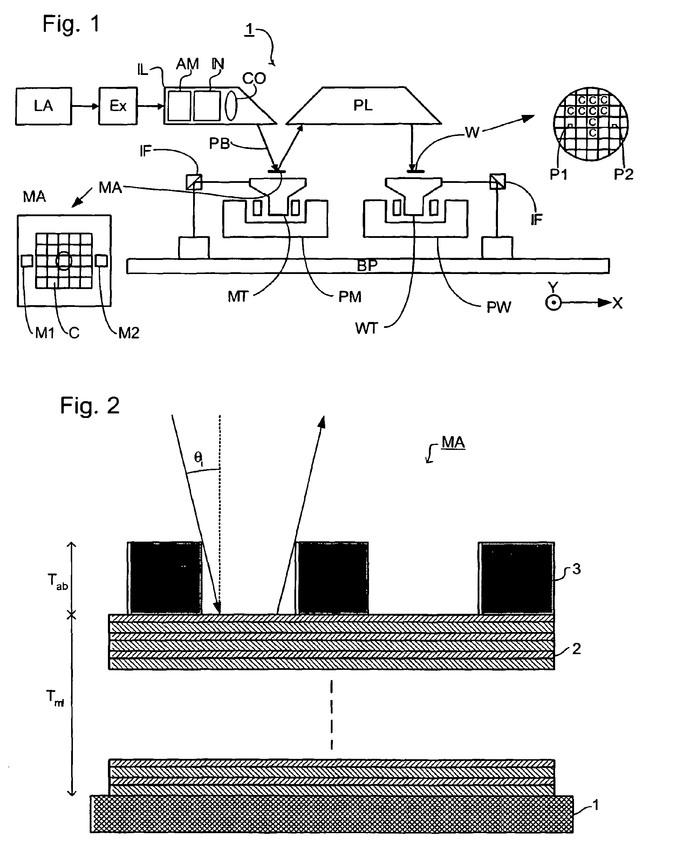

Figure 1 schematically depicts a lithographic projection apparatus that may be used to perform the method of the invention. The apparatus comprises:

- an illumination system (illuminator) IL for providing a projection beam PB of radiation (e.g. EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and (σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

Figure 2 shows the mask MA, which comprises a substrate 1 on which is provided a multilayer 2 forming a distributed Bragg reflector overlain by a patterned absorber layer 3. The multilayer may comprise 40 or more periods of alternating layers of Molybdenum (Mo) and Silicon (Si) or Molybdenum and Beryllium (Be). Other materials and three or four layer periods may also be used. Further details of suitable reflectors formed of multilayer stacks may be found in EP-A-1 065 532, EP-A-1 065 568 and EP-A-1 260 862, which documents are hereby incorporated by reference. Each period of the multilayer is approximately half a wavelength thick so that the total thickness of the multilayer, $T_{ml}$, is about 270nm or more. Absorber layer 3 may be formed of Chrome (Cr), Tantalum (Ta) or other Ta containing materials such as TaBN. To provide a sufficient degree of absorption, its thickness, $T_{ab}$, is 50 or 100nm or more.

Because the illumination and projection systems are formed of reflective optical elements, the mask must be illuminated obliquely, e.g. at an angle, $\theta_i$, of about 6° to the normal.

The combination of the oblique illumination and the thickness of the multilayer and absorber layer causes a number of deformations in the projected image, as compared to the image that would be produced by an ideal, thin binary mask. As can easily be seen, the shadowing effect of the thick absorber will cause opaque features to be imaged with greater width than the feature on the mask and this effect will differ between horizontal and vertical features because of the different effective angle of illumination. The thickness of the multilayer and the extent to which the illumination radiation penetrates the multilayer further complicates the situation and introduces various imaging artifacts.

The various effects of the thick, reflective mask can be simulated and are found to be pattern dependent - the effects on vertical and horizontal lines differ and the effects are different according to pattern density for example. The resulting deformations of the aerial images may be characterized as or approximated by aberrations, which can be expressed in terms of Zernike polynomials. According to the invention, aberrations in the projection system are introduced and/or controlled to counteract the effects of the mask thickness and oblique illumination.

The aberrations may be introduced or controlled by control of the position and/or orientations of the individual mirrors of the projection system and the mask and substrates. Positioning systems for the individual mirrors of the projection system are included in an EUV lithographic projection system to provide the necessary image stability and may be used to effect the aberration control of the present invention without further modification, simply by the use of different setpoints. The present invention may, alternatively or in addition, make use of adaptive mirrors, such as described in EP-A-1 174 770.

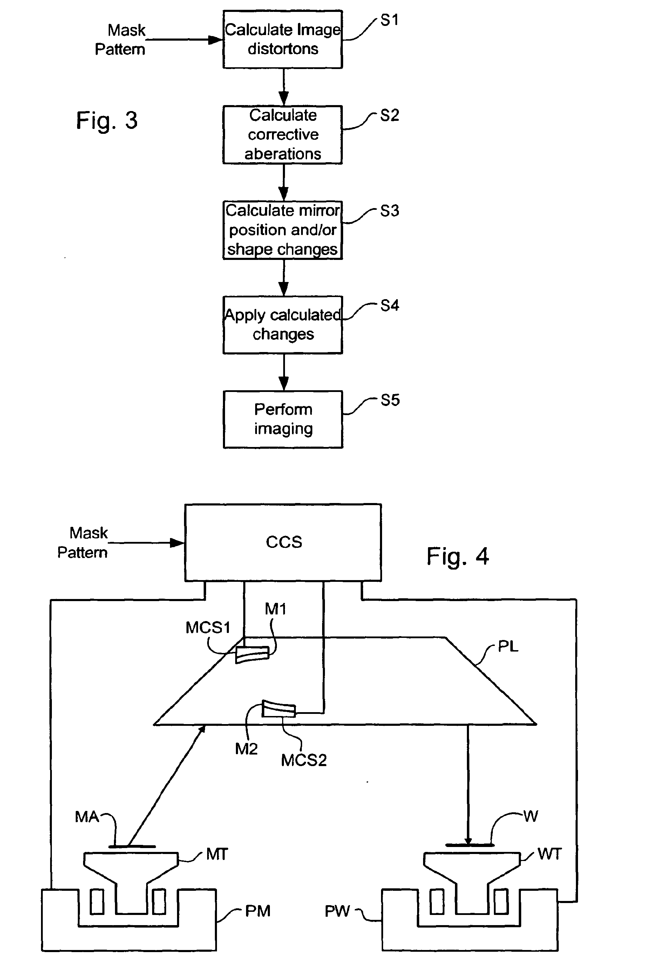

Figure 3 illustrates a basic process of the invention. For a specific mask pattern, first the image deformations that will occur in imaging it are calculated in step S1. Next, the required corrective aberrations are calculated in step S2 and the table position and mirror position and/or shape changes required to effect these aberrations are calculated in step S3. The calculated changes are applied to the projection system in step S4 before imaging takes place in step S5. Steps S1 to S3 may be carried out in advance of a projection and the results transferred to the lithographic projection system when required. If the image deformations vary across the pattern to be imaged and the relevant actuators are sufficiently responsive, the relevant changes may be applied during an imaging scan as well as in advance of it.

A system to effect the method of the invention is shown in Figure 4. The mask pattern data or precomputed settings for the stage and mirror positions and/or shapes are provided to the central control system CCS of the lithographic apparatus. If mask pattern data are provided, the central control system computes the desired settings for the stage and mirror positions and/or shapes. Prior to and/or during a scanned exposure, the central control system controls the mask table MT and substrate table WT positions, via respective positioning system PM, PW, as well as the positions and/or shapes of some or all mirrors M1, M2 in the projection system PL, via respective control system MCS1, MCS2. Only two mirrors in the projection system PL are shown in Figure 4 however, the projection system may comprise four or more mirrors.

In a preferred embodiment of the invention, the aberrations introduced to control the mask-induced effects are defined by Zernike polynomials Z5 (astigmatism HV), Z9 (spherical aberration) and Z12 (astigmatism HV - higher order). Other aberrations that might be used include Z2 (tilt in X), Z3 (tilt in Y), Z4 (defocus), Z6 (astigmatism 45°/135°), Z7 (coma X), Z8 (coma Y) and Z13 (astigmatism 45°/135° - higher order). These polynomials take the form:

Z2:
$$r \cdot \cos(\theta)$$

Z3:
$$r \cdot \sin(\theta)$$

Z4:
$$2 \cdot r^2 - 1$$

Z5:
$$r^2 \cdot \cos(2 \cdot \theta)$$

Z6:
$$r^2 \cdot \sin(2 \cdot \theta)$$

Z7:
$$\left(3 \cdot r^3 - 2 \cdot r\right) \cdot \cos(\theta)$$

Z8:
$$\left(3 \cdot r^3 - 2 \cdot r\right) \cdot \sin(\theta)$$

Z9:
$$6 \cdot r^4 - 6 \cdot r^2 + 1$$

Z12:
$$\left(4 \cdot r^4 - 3 \cdot r^2\right) \cdot \cos(2 \cdot \theta)$$

Z13:
$$\left(4 \cdot r^4 - 3 \cdot r^2\right) \cdot \sin(2 \cdot \theta)$$

Z4 can be used to correct a focus shift independent of structure size and type. Z6 and Z13 have the same effect on the difference between 45° and 135° degree lines as do Z5 and Z12 on the difference between horizontal and vertical lines. Z5 and Z6 are equally important in correcting contact hole ellipticity. Z7 and Z8 affect horizontal and vertical lines respectively.

Higher order aberrations may also be employed to improve control if desired and/or feasible.

It is noted that Zernike polynomials may be expressed in different forms, for example with and without normalization coefficients, and may be numbered in various sequences, e.g. increasing in order of angle then radius or *vice versa.* Also, other forms for the expression of aberrations are known, e.g. Seidel aberration polynomials. The present invention is not limited to a particular form of expression of the aberrations introduced and embraces the calculation of and addition of aberrations expressed in other forms.

Example 1

An example of the invention, which has been simulated, will now be described.

Images without aberration - pure - were simulated for both horizontal and vertical lines at dense and semi isolated for 30nm and 50nm features. Due to the simulator software, horizontal lines had to be simulated as vertical, but corrections in aberration sensitivity have been made for this. Best Focus shifts and Isofocal Tilt were calculated.

More simulations were then performed for the same features with 1nm of a single aberration input. Analysis of Best Focus shifts and Isofocal Tilts were repeated. Sensitivity data was calculated for each feature and aberration combination. Sensitivity is equal to the change in a parameter due to (+)1nm of an aberration. (For best focus shift the sensitivity units are nm/nmaberration and for isofocal tilt, nm/$\mu$m focus /nm aberration). Only Solid-EUV[TM] relative sensitivities for aberrations are considered here for optimization purposes i.e. changes in best focus shift or isofocal tilt relative to the position of the "pure" image. These results best describe the baseline before aberration input and are often the standard technique for assessing process windows. Note that the positive and negative shift positions, and associated sensitivities, are described here in terms of the system coordinates.

The present invention aims to position the focus shifts and isofocal tilt values to remove the differences between horizontal and vertical features, and between dense and isolated features, thus allowing overlap of the process windows and enabling a wider range of simultaneous imaging. Ideally, all features, of different shapes, linewidths, pitches (whether isolated or dense) and orientations should have a common best focal plane, i.e. all best focus shift values are the same, and an iso-focal tilt of zero. Each Zernike aberration works on different feature types and orientations in a different way. By programming an Excel[TM] sheet to automatically plot the resultant position after interaction with a single Zernike or several Zernikes, it is possible to experiment with different combinations and levels of Zernike input, to flatten out the plots (removing pitch dependence) and to bring the H and V plots closer together. Zernikes can be input in either the positive or negative directions in the system.

As an example of the method employed, 30nm lines on a bright field mask were considered. The initial best focus shift and isofocal tilt results for pure images for normal incidence, equivalent to system vertical lines, and 6° incidence, equivalent to system horizontal lines, are shown below for different pitches. Also detailed are the calculated sensitivity values with respect to Z5 and Z12 astigmatism and Z9 spherical for normal and 6° incidence. These Zernikes can be adjusted in a lithographic projection apparatus.

Table 1: BFshifts and IFT : pure images, starting values

|  | BFshift_V | BFshift_H | IFT_V | IFT_H |
|---|---|---|---|---|
| pitch 60nm (D) | -5 | 10 | -0.5 | -0.5 |
| pitch 150nm (I) | 5 | 20 | 8 | 8.5 |

Table 2: Relative Sensitivities (in system co-ordinates)

| BFshift | dense | | iso | | IFT | dense | | iso | |
|---|---|---|---|---|---|---|---|---|---|
| | N | 6 | N | 6 | | N | 6 | N | 6 |
| Z5 | -25 | 40 | -25 | 40 | Z5 | 0 | 0.5 | -0.5 | 0 |
| Z12 | -5 | 20 | 15 | -25 | Z12 | -1.5 | 1.5 | 6 | -5.5 |
| Z9 | 20 | 5 | 55 | 60 | Z9 | -1.5 | -1.5 | 11 | 6.5 |

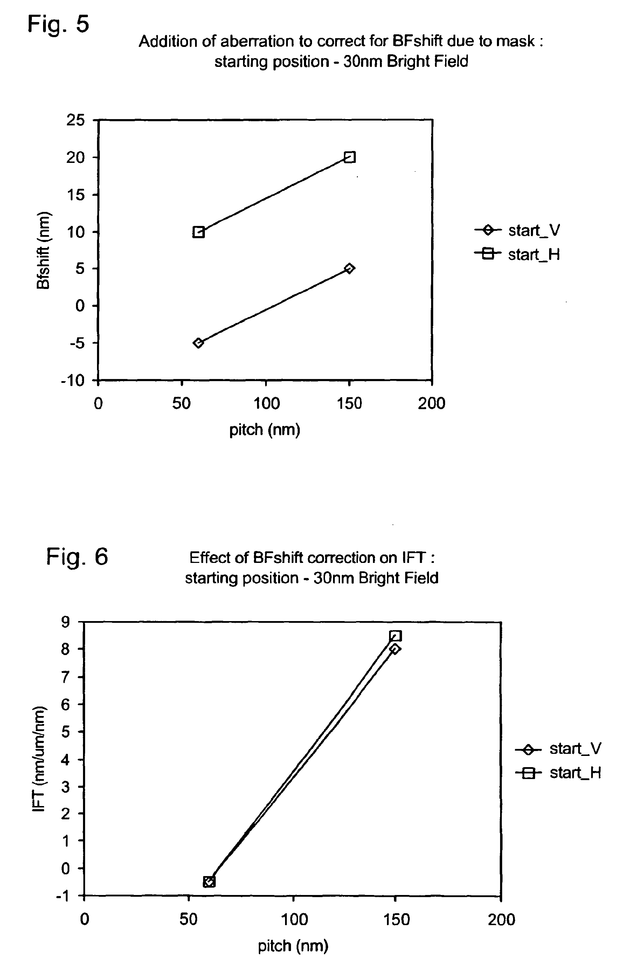

When plotted, the starting positions for BFshift and IFT appear as shown in Figures 5 and 6. The differences in parameters between dense and isolated lines and between horizontal and vertical lines are clearly visible.

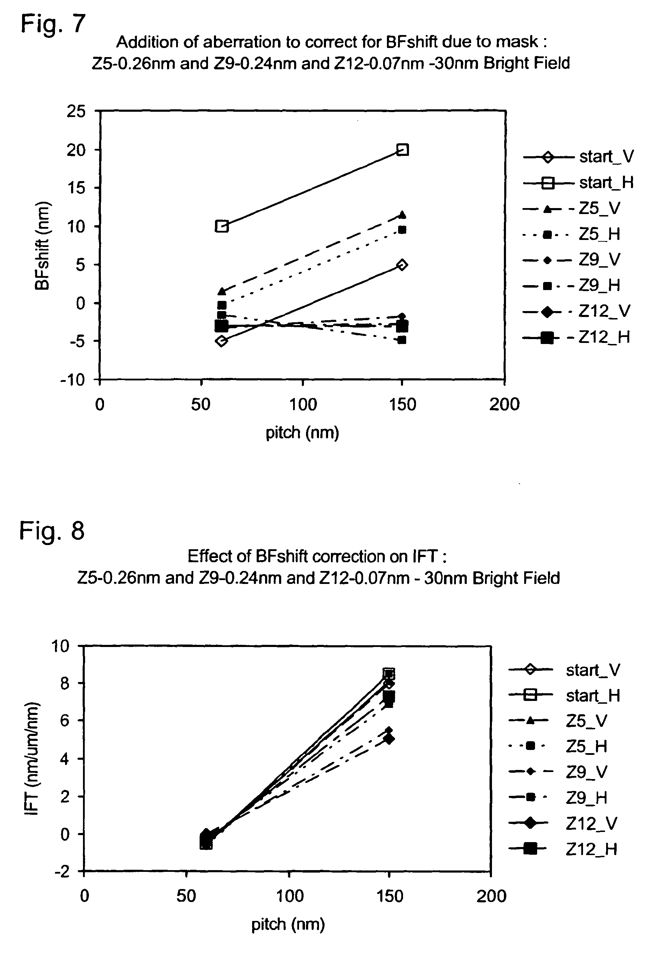

The best results so far for 30nm and 50nm bright field lines are shown in Figures 7 to 17, together with the effect on IFT, which such a correction would trigger. Note that from the starting position Zernikes are added in the order of the graph legend, thus the last Zernike in the list is the final position of the BF and IFT plots and a summation of all Zernike inputs.

Figure 7 shows the effect of adding aberrations to correct for best focus shift due to the mask. The values of the Zernike aberrations added were: Z5= -0.26nm, Z9=-0.24nm and Z12=-0.07nm. Figure 8 then illustrates the effect of the correction on isofocal tilt. A clear improvement can be seen - both the best focus shift and isofocal tilt become less dependent on pitch after the corrective aberrations are introduced.

The best results obtained for different features are shown in Table 3 below:

| | Z5 (nm) | Z9 (nm) | Z12 (nm) | starting focus range (nm) | resulting focus range (nm) | starting IFT maxvalue | IFT max after BF correction |
|---|---|---|---|---|---|---|---|
| 30nm | -0.26 | -0.24 | -0.07 | 25 | 0 | 8.5 | 7.3 |
| 50nm | -0.18 | -0.22 | -0.18 | 15 | 0 | 10.5 | 7.8 |

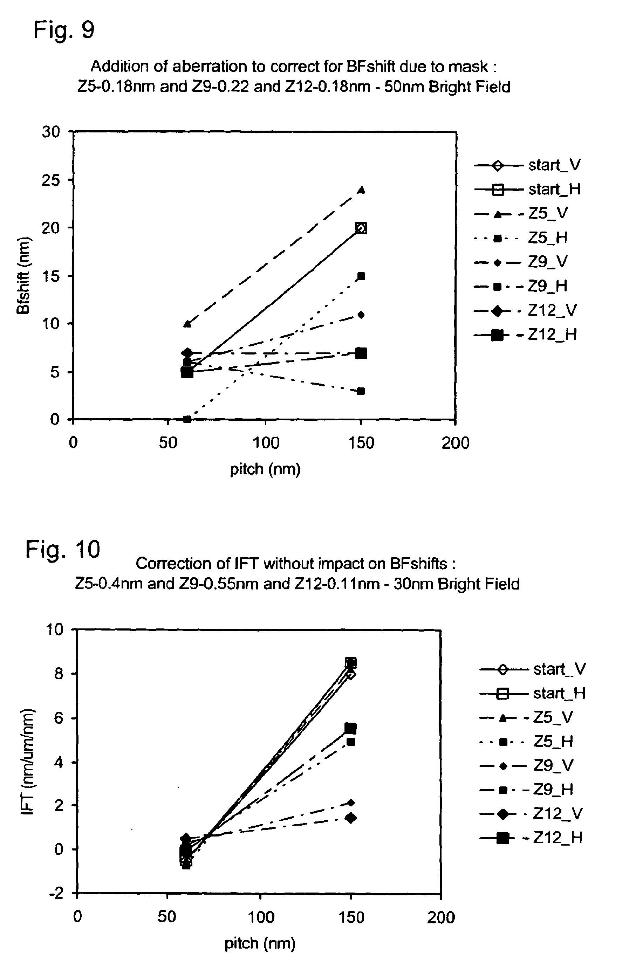

Comparing Figures 7 and 9, illustrates the improvements obtained for 30nm and 50nm lines in a bright field.

Of course it is also possible to optimize for IFT. However, this results in a different set of aberration inputs and thus affects the BFshift positions. Examples for 30nm and 50nm lines on bright field mask are shown in Table 4 below:

| | Z5 (nm) | Z9 (nm) | Z12 (nm) | starting focus range (nm) | resulting focus range (nm) | starting IFT maxvalue | IFT max after BF correction |
|---|---|---|---|---|---|---|---|
| 30nm | -0.4 | -0.55 | 0.11 | 25 | 25 | 8.5 | 4.3 |
| 50nm | -0.34 | -0.37 | -0.11 | 15 | 15 | 10.5 | 6.1 |

These results are shown in Figures 10, for 30nm lines, and 12, for 50nm lines.

It is further possible to search for a combination of aberrations that give the best solution for both best focus shift and isofocal tilt, which involves weighting the relative importance of best focus shift and isofocal tilt.

The above examples demonstrate that it is possible to compensate for BFshift effects due to a reflective mask and oblique illumination in such a way that BFshift differences between dense and isolated lines, and between horizontal and vertical lines, can be reduced. This will assist in bringing process windows for different features closer together. It is also possible to use IFT as the metric for level of aberration input and reduce the differences between different structure types. The choice of metric is important as improvement in IFT may worsen BFshift performance, and visa versa.

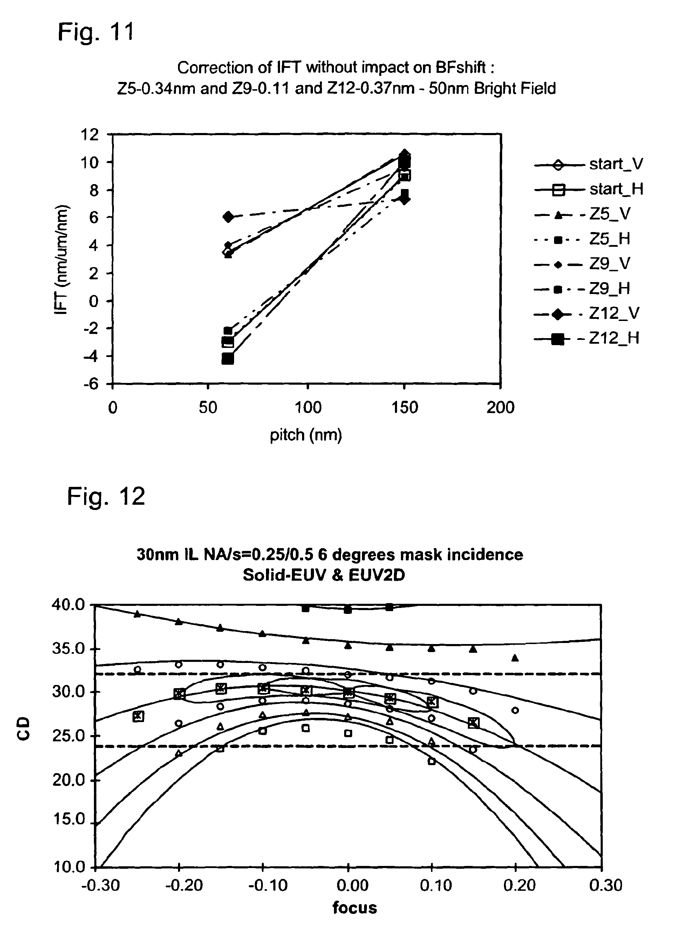

To confirm the usefulness of the invention, using the adjustments described above, images in resist were simulated to investigate the effect of correction of BFshifts on CDU (Critical Dimension Uniformity). Prolith[TM] was used for simulation with the EUV-2D resist model, resist thickness 120nm. A CDU prediction model used the resist images as a base and, together with user inputs of focus and energy budgets, calculated the resultant CDU performance for various focus ranges. Figures 12 to 16 clearly show that altering the IFT and BF parameters enhances the CDU performance, thus indicating the relevance of BFshift and IFT correction by aberration input.

Figure 12 shows the simulated CD response in resist versus energy and focus for 30nm isolated lines printed with NA=0.25, σ=0.5 and 6 degrees MAI, thus representing the horizontal lines. In the graph, the three elliptically shaped CD contours indicate the CD variation as function of system energy and focus errors. Each CD contour has represents a different focus setting, 0 and +/-100nm. The CD response in Figure 12 shows a mask-induced isofocal tilt leading to poor CD uniformity.

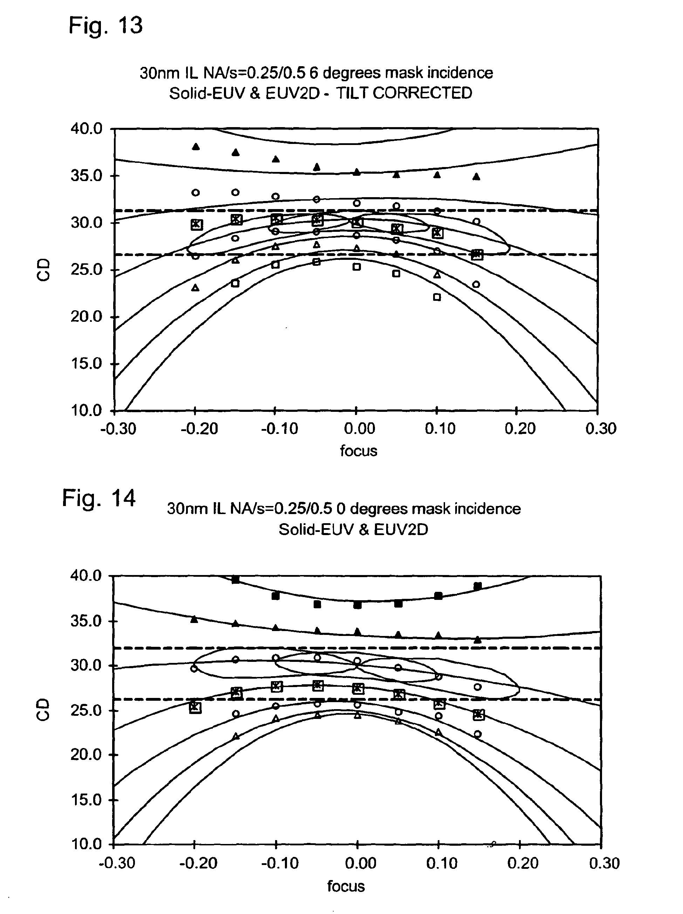

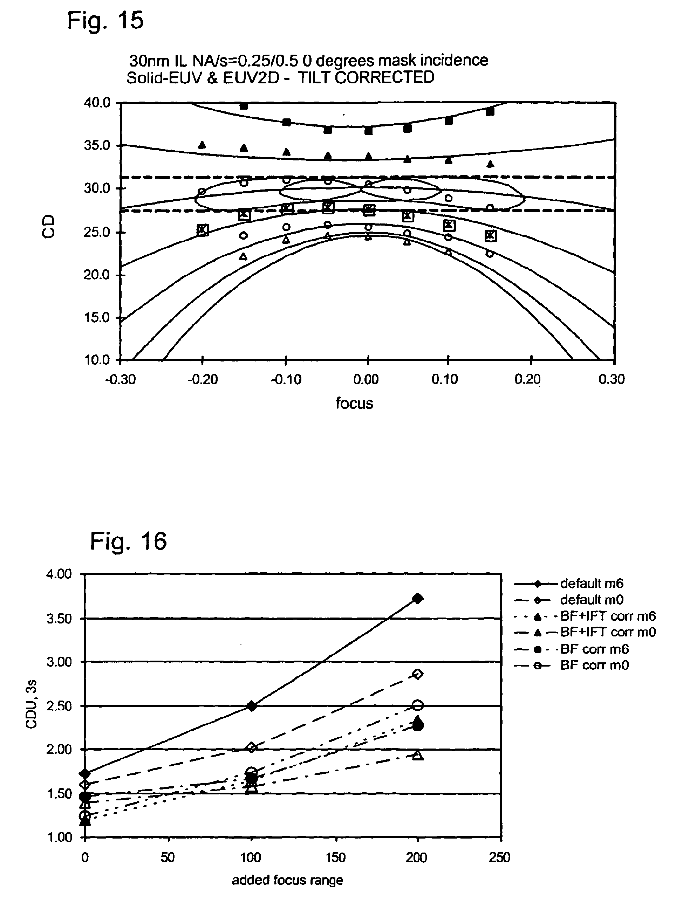

Figure 13 shows the CD response versus energy and focus that is mathematically corrected for the isofocal tilt. The three CD contours show less CD variation indicating that this tilt correction improves CD uniformity. Figure 14 shows the CD response in resist for 0 degrees MAI presenting the vertical lines. Figure 15 shows that again isofocal tilt correction improves CDU.

Figure 16 combines all CDU information of Figures 12-15. The predicted CDU is plotted against the focus range. The impact of the mathematical best focus (BF) and isofocal tilt (IFT) correction on CDU are shown. For example, the CDU for 0nm focus range is based on the black CD contours where the best focus is set at 0nm. The CDU for 200nm focus range is based no all three CD contours for the 0 and +/-100nm focus settings.

The Figure shows that the CDU can be improved substantially by BF and IFT correction for both horizontal and vertical lines. The CDU improves most for the largest focus range.

Example 2

As a follow up to the first example, which addressed mask-induced focus related effects and solutions (Z plane), a second example addressed the mask-induced image CD and displacement effects and methods to compensate these (X-Y plane). The simulations results described here are based on the same Solid-EUV$^{TM}$ produced aerial images as in the first example. These aerial images were imported into Prolith$^{TM}$ v7.1 to calculate the image CD and displacement.

As function of mask angle of incidence (MAI), absorber thickness, feature type and NA/illumination setting a mask induced image CD offset will occur. The dominant effect is a CD variation between features as function of structural orientation such as a HV bias. For contact holes, the mask will induce ellipticity.

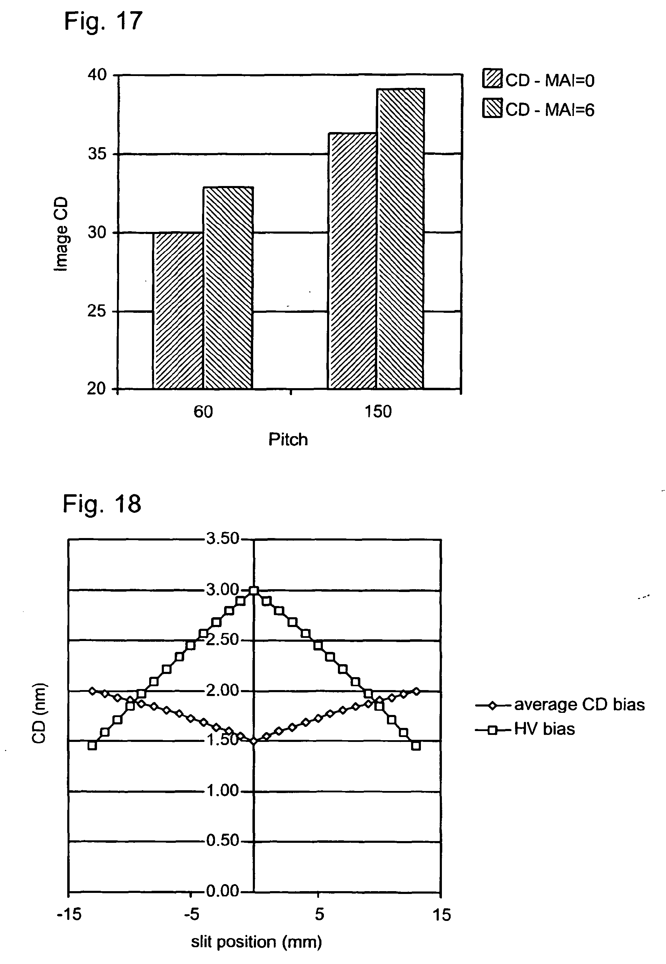

Figure 17 shows image CD as function of MAI and pitch for 30nm lines with NA=0.25, σ=0.5. It can be seen that the CD bias between MAI of 0 and 6 degrees is 2.9nm for dense lines and 2.8nm for (semi)isolated lines. This information yields a sensitivity of 0.5nm CD / degree MAI.

Figure 18 shows mask-induced CD and HV bias as function of slit position, based on the MAI variation for horizontal and vertical lines and the CD sensitivity to MAI. The issues are the HV bias, the HV bias and average CD variation across the slit.

The consequent mask-induced contact hole ellipticity variation across the slit may be compensated by projection lens aberrations, most notably astigmatism (Z5). The HV bias can be compensated in combination with the BF and IFT compensation by optimized project lens aberration settings, most notably Z5, Z9 and Z12.

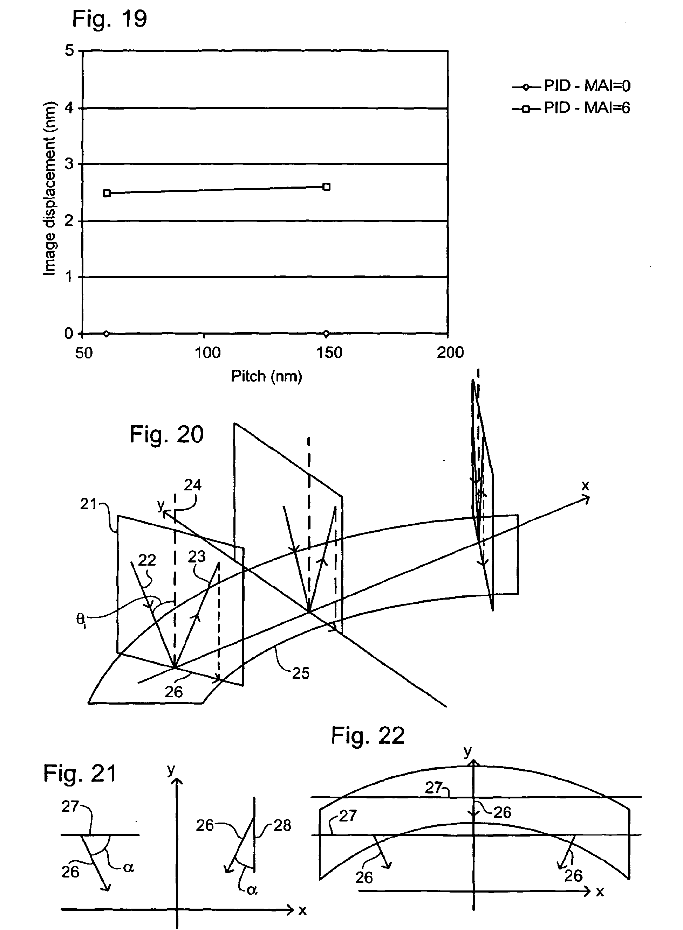

As function of mask angle of incidence (MAI), absorber thickness, feature type and NA/illumination setting a mask induced image displacement will occur. As with the image CD effects, the image displacement induced by the mask will be slit position dependent. Figure 19 shows image displacement as function of MAI and pitch for 30nm lines with NA=0.25, σ=0.5, demonstrating a strong bias between horizontal features, for which the mask angle of incidence is 6°, and vertical features for which the mask angle of incidence is 0°. This effect can be compensated for by the introduction of aberrations Z2, Z3 and Z7, where:

$$Z2 = r \cos\theta$$

$$Z3 = r \sin\theta$$

$$Z7 = (3r^3 - 2r) \cos\theta$$

Mask Angle of Incidence

The term "mask angle of incidence" as used above can be explained with reference to Figures 20 to 22.

In Figures 20 to 22, the following reference numerals are used:

21     plane of incidence;
22     incident central illumination ray;
23     reflected central patterned ray;
24     normal to plane of pattern;
25     arcuate (part-annular) illumination area on plane of pattern;
26     component of reflected central patterned ray, in the plane of the pattern;
27     horizontal feature;

28 vertical feature; and

α angle between feature and component of reflected central patterned ray.

The mask angle of incidence MAI is defined in the present text and claims as

$$\mathrm{MAI} = (\alpha / 90^\circ) * \theta_i$$

In an EUV projection apparatus, the illuminated field 25 is typically arcuate, and incident central rays of illumination 23 lie in planes of incidence 21 which intersect each other along a line (not shown in Figure 20) perpendicular to the x,y plane in Figure 20, intersecting the y-axis. As a consequence, the corresponding reflected central patterned rays have components 26 in the x,y plane converging to a point (not shown in Figure 20) on the y-axis. The shadowing effect of the thick absorber depends on the angle α between a feature and the component 26 of the reflected central patterned ray 23 at the position of that feature. In Figure 21 this angle is shown for a horizontal feature 27 and a vertical feature 28. From Figure 22, which shows this angle for horizontal features 27 at different x positions, it is clear that the angle α varies in accordance with the position of the feature along the x-axis. Thus, in general, the shadowing effect is dependent on the position of a feature along the x axis, and consequently lithographic errors exhibit an x dependence in accordance with the variation of α. According to the present invention, preferably Z2, Z3, and Z7 (as defined above) are controlled to correct for lithographic errors related to above mentioned x-dependent shadowing effect.

While specific embodiments of the invention have been described above, it will be appreciated that the invention may be practiced otherwise than as described. The description is not intended to limit the invention which is defined by the claims.

**Claims**

1. A device manufacturing method comprising the steps of:

    - providing a substrate (W) that is at least partially covered by a layer of radiation-sensitive material;
    - providing a projection beam (PB) of radiation using a radiation system;
    - using a reflective mask (MA) on which a pattern is defined by a thick absorber to endow the projection beam with said pattern in its cross-section;
    - projecting the patterned beam of radiation onto a target portion of the layer of radiation-sensitive material; and

    **characterised in that**
    compensating for imaging artefacts caused by shadowing effects of said thick absorber;

    - said compensation comprises controlling or creating system aberrations in the projection system used in said step of projecting the patterned beam.

2. A method according to claim 1 further comprising the step of calculating for said pattern the optimum aberrations to be effected in said projection system, said calculation taking account of one or more parameters to be used in said step of projecting, said parameters being selected from the group comprising mask angle of incidence (MAI), absorber thickness, absorber material, feature type and NA/illumination settings.

3. A method according to claim 1 or 2 wherein said system aberrations comprise one or more of Zernike polynomials Z2 (tilt in X), Z3 (tilt in Y), and Z7 (coma X), where these polynomials take the form:

    Z2:

$$r \cdot \cos(\theta)$$

    Z3 :

$$r \cdot \sin(\theta)$$

Z7:

$$\left(3 \cdot r^3 - 2 \cdot r\right) \cdot \cos(\theta)$$

4. A method according to claim 1, 2 or 3 wherein said aberrations are introduced and/or controlled so that values of at least one imaging metric for different feature types appearing in said pattern are brought closer together.

5. A method according to claim 4 wherein said at least one imaging metric is selected from the group comprising: best focus shift, isofocal tilt, critical dimension, critical dimension uniformity, overlay, telecentricity, pattern asymmetry, pitch linearity and iso-dense bias.

6. A method according to claim 4 or 5 wherein said different features have different densities, different orientations and/or different critical dimensions.

7. A method according to claim 4, 5 or 6 wherein said aberrations are introduced so as to bring process windows for said different features closer together.

8. A method according to any one of the preceding claims wherein said system aberrations comprise one or more of Zernike polynomials Z4 (defocus), Z5 (astigmatism HV), Z6 (astigmatism 45°/135°), Z8 (coma Y), Z9 (spherical aberration), Z12 (astigmatism HV - higher order) and Z13 (astigmatism 45°/135° - higher order), where these polynomials take the form:

Z4:

$$2 \cdot r^2 - 1$$

Z5:

$$r^2 \cdot \cos(2 \cdot \theta)$$

Z6:

$$r^2 \cdot \sin(2 \cdot \theta)$$

Z8:

$$\left(3 \cdot r^3 - 2 \cdot r\right) \cdot \sin(\theta)$$

Z9:

$$6 \cdot r^4 - 6 \cdot r^2 + 1$$

Z12:

$$\left(4 \cdot r^4 - 3 \cdot r^2\right) \cdot \cos(2 \cdot \theta)$$

Z13:

$$\left(4 \cdot r^4 - 3 \cdot r^2\right) \cdot \sin(2 \cdot \theta)$$

**9.** A method according to claim 2 wherein said step of calculating comprises the steps of:

determining the sensitivities of different features in said pattern to different aberrations;
determining the optimum combination of aberrations using the determined sensitivities.

**10.** A method according to claim 9 wherein said sensitivities are determined by simulating images of said different features with different amounts and/or combinations of aberrations.

**11.** A method according to any one of the preceding claims wherein said absorber has a thickness of greater than 50 nm.

**12.** A computer method for determining system aberrations to be effected in a projection system of a lithographic apparatus to compensate for imaging artifacts caused by a mask, the method comprising instructing the computer to perform the steps of:

determining the sensitivities of different features in said pattern to different aberrations;
determining the optimum combination of aberrations using the determined sensitivities; **characterised in that** said imaging artifacts are caused by shadowing effects of a thick absorber which defines a pattern in a reflective mask.

**13.** A method according to claim 12 wherein said step of determining the sensitivities comprises simulating images of said different features with different amounts and/or combinations of aberrations.

**14.** A method according to claim 12 or 13 wherein said step of determining the optimum combination of aberrations comprises determining a combination of aberrations to be effected so that values of at least one imaging metric for different feature types appearing in said pattern are brought closer together.

**15.** A method according to claim 14 wherein said at least one imaging metric is selected from the group comprising: best focus shift, isofocal tilt, critical dimension, critical dimension uniformity, overlay, telecentricity, pattern asymmetry, pitch linearity and iso-dense bias.

**16.** A method according to claim 14 or 15 wherein said different features are dense and isolated lines, and/or horizontal and vertical lines, and/or lines of different widths.

**17.** A method according to claim 14 or 15 wherein said step of determining the optimum combination of aberrations comprises determining a combination of aberrations to be effected so as to bring process windows for said different features closer together.

**18.** A method according to any one of claims 12 to 17 wherein said system aberrations are Zernike polynomials Z2 (tilt in X), Z3 (tilt in Y), and Z7 (coma X), where these polynomials take the form:

Z2:

$$r \cdot \cos(\theta)$$

Z3:

$$r \cdot \sin(\theta)$$

Z7:

$$\left(3 \cdot r^3 - 2 \cdot r\right) \cdot \cos(\theta).$$

**19.** A computer program comprising code means that, when executed on a computer system, instruct the computer system to perform the steps of any one of claims 12 to 18.

**20.** A computer program comprising code means that, when executed on a computer system, instructs the computer system to control a lithographic projection apparatus by effecting system aberrations in the projection system of the lithographic projection apparatus to optimize imaging of a mask, by compensating for imaging artefacts caused by said mask; **characterised in that** said imaging artefacts are caused by shadowing effects of a thick absorber which defines a pattern in a reflective mask.

**Patentansprüche**

**1.** Verfahren zur Herstellung eines Bauelements, das folgende Schritte umfasst:

• Bereitstellen eines Substrats (W), das zumindest teilweise von einer Schicht aus strahlungssensitivem Material bedeckt ist;
• Bereitstellen eines Projektionsstrahls (PB) aus Strahlung unter Verwendung eines Strahlungssystems;
• Verwenden einer reflektierenden Maske (MA), auf der ein Muster durch einen dicken Absorber definiert ist, um dem Projektionsstrahl in seinem Querschnitt das Muster aufzuprägen;
• Projizieren des gemusterten Strahls aus Strahlung auf einen Zielbereich der Schicht aus strahlungssensitivem Material; und
• Kompensieren von Abbildungsartefakten, die durch abschattende Effekte des dicken Absorbers hervorgerufen werden;

**dadurch gekennzeichnet, dass** die Kompensation das Steuern oder Erzeugen von Systemaberrationen im Projektionssystem umfasst, die bei dem Schritt des Projizierens des gemusterten Strahls verwendet werden.

**2.** Verfahren nach Anspruch 1, das ferner für das Muster den Schritt des Berechnens der optimalen Aberrationen umfasst, die in dem Projektionssystem bewirkt werden sollen, wobei die Berechnung einen oder mehrere in dem Projektionsschritt zu verwendende Parameter berücksichtigt, wobei die Parameter aus der Gruppe gewählt sind, die den Maskeneinfallswinkel (MAI), die Absorberdicke, das Absorbermaterial, die Strukturart und die NA/Beleuchtungseinstellungen umfasst.

**3.** Verfahren nach Anspruch 1 oder 2, wobei die Systemaberrationen ein oder mehrere Zernike-Polynominale Z2 (Neigung in X), Z3 (Neigung in Y), und Z7 (Koma X) umfassen, wobei diese Polynominale folgende Form annehmen:

Z2:

$$r \cdot \cos(\theta)$$

Z3:

$$r \cdot \sin(\theta)$$

Z7:

$$(3 \cdot r^3 - 2 \cdot r) \cdot \cos(\theta)$$

**4.** Verfahren nach Anspruch 1, 2 oder 3, wobei die Aberrationen so zugeführt und/oder gesteuert werden, dass Werte von wenigstens einer Abbildungsmetrik für unterschiedliche Strukturarten, die in dem Muster erscheinen, näher zusammengebracht werden.

**5.** Verfahren nach Anspruch 4, wobei die wenigstens eine Abbildungsmetrik aus der Gruppe bestehend aus: beste Brennpunktverschiebung, Isofokalneigung, kritische Dimension, Gleichförmigkeit der kritischen Dimension, Überlagerung, Telezentrizität, Musterasymmetrie, Abstandslinearität und isodichte Vorspannung ausgewählt ist.

**6.** Verfahren nach Anspruch 4 oder 5, wobei die unterschiedlichen Strukturen unterschiedliche Dichten, unterschiedliche Ausrichtungen und/oder unterschiedliche kritische Dimensionen aufweisen.

**7.** Verfahren nach Anspruch 4, 5 oder 6, wobei die Aberrationen so zugeführt sind, dass sie Verfahrensfenster für die unterschiedlichen Strukturen näher zusammenbringen.

**8.** Verfahren nach einem der vorhergehenden Ansprüche, wobei die Systemaberrationen ein oder mehrere Zernike-Polynominale Z4 (Defokussierung), Z5 (Astigmatismus HV), Z6 (Astigmatismus 45°/135°), Z8 (Koma Y), Z9 (sphärische Aberration), Z12 (Astigmatismus HV - höherer Ordnung) und Z13 (Astigmatismus 45°/135° - höherer Ordnung) umfassen, wobei diese Polynominale folgende Form annehmen:

Z4:

$$2 \cdot r^2 - 1$$

Z5:

$$r^2 \cdot \cos(2 \cdot \theta)$$

Z6:

$$r^2 \cdot \sin(2 \cdot \theta)$$

Z8:

$$(3 \cdot r^3 - 2 \cdot r) \cdot \sin(\theta)$$

Z9:

$$6 \cdot r^4 - 6 \cdot r^2 + 1$$

Z12:

$$(4 \cdot r^4 - 3 \cdot r^2) \cdot \cos(2 \cdot \theta)$$

Z13:

$$(4 \cdot r^4 - 3 \cdot r^2) \cdot \sin(2 \cdot \theta)$$

9.  Verfahren nach Anspruch 2, wobei der Schritt des Berechnens folgende Schritte umfasst:

Bestimmen der Empfindlichkeiten unterschiedlicher Strukturen in dem Muster auf unterschiedliche Aberrationen;
Bestimmen der optimalen Kombination von Aberrationen unter Verwendung der bestimmten Empfindlichkeiten.

10.  Verfahren nach Anspruch 9, wobei die Empfindlichkeiten bestimmt werden durch Simulieren von Bildern der unterschiedlichen Strukturen mit unterschiedlichen Ausmaßen und/oder Kombinationen von Aberrationen.

11.  Verfahren nach einem der vorhergehenden Ansprüche, wobei der Absorber eine Dicke größer 50nm aufweist.

12.  Computer-Verfahren zum Bestimmen von Systemaberrationen, die in einem Projektionssystem einer lithographischen Vorrichtung bewirkt werden sollen, um Abbildungsartefakte zu kompensieren, die durch eine Maske hervorgerufen werden, wobei das Verfahren den Befehl an den Computer umfasst, folgende Schritte durchzuführen:

Bestimmen der Empfindlichkeiten unterschiedlicher Strukturen in dem Muster auf unterschiedliche Aberrationen;
Bestimmen der optimalen Kombination von Aberrationen unter Verwendung der bestimmten Empfindlichkeiten;

**dadurch gekennzeichnet, dass** die Abbildungsartefakte durch abschattende Effekte eines dicken Absorbers hervorgerufen werden, der ein Muster in einer reflektierenden Maske definiert.

13.  Verfahren nach Anspruch 12, wobei der Schritt des Bestimmens der Empfindlichkeiten das Simulieren von Bildern der unterschiedlichen Strukturen mit unterschiedlichen Ausmaßen und/oder Kombinationen von Aberrationen umfasst.

14.  Verfahren nach Anspruch 12 oder 13, wobei der Schritt des Bestimmens der optimalen Kombination von Aberrationen das Bestimmen einer Kombination von Aberrationen umfasst, die bewirkt werden sollen, so dass Werte von wenigstens einer Abbildungsmetrik für unterschiedliche Strukturarten, die in dem Muster erscheinen, näher zusammengebracht werden.

15.  Verfahren nach Anspruch 14, wobei die wenigstens eine Abbildungsmetrik aus der Gruppe bestehend aus: beste Brennpunktverschiebung, Isofokalneigung, kritische Dimension, Gleichförmigkeit der kritischen Dimension, Überlagerung, Telezentrizität, Musterasymmetrie, Abstandslinearität und isodichte Vorspannung ausgewählt ist.

16.  Verfahren nach Anspruch 14 oder 15, wobei die unterschiedlichen Strukturen dichte und isolierte Linien und/oder horizontale und vertikale Linien und/oder Linien unterschiedlicher Breite sind.

17.  Verfahren nach Anspruch 14 oder 15, wobei der Schritt des Bestimmens der optimalen Kombination von Aberrationen das Bestimmen einer Kombination von Aberrationen umfasst, die zu erzielen sind, um Verfahrensfenster für die unterschiedlichen Strukturen näher zusammen zu bringen.

18. Verfahren nach einem der vorhergehenden Ansprüche 12 bis 17, wobei die Systemaberrationen Zernike-Polynominale Z2 (Neigung in X), Z3 (Neigung in Y), und Z7 (Koma X) umfasst, wobei diese Polynominale folgende Form annehmen:

Z2:

$$r \cdot \cos(\theta)$$

Z3:

$$r \cdot \sin(\theta)$$

Z7:

$$(3 \cdot r^3 - 2 \cdot r) \cdot \cos(\theta)$$

19. Computer-Programm, das Code-Einrichtungen umfasst, die bei Ausführung auf einem Computer-System dem Computer-System den Befehl erteilen, die Schritte von einem der Ansprüche 12 bis 18 durchzuführen.

20. Computer-Programm, das Code-Einrichtungen umfasst, die bei Ausführung auf einem Computer-System dem Computer-System den Befehl erteilen, eine lithographische Projektionsvorrichtung zu steuern, indem Systemaberrationen in dem Projektionssystem der lithographischen Projektionsvorrichtung durchgeführt werden, um die Abbildung einer Maske zu optimieren, indem Abbildungsartefakte kompensiert werden, die durch die Maske hervorgerufen worden sind,
**dadurch gekennzeichnet, dass**
die Abbildungsartefakte durch abschattende Effekte eines dicken Absorbers hervorgerufen werden, der ein Muster in einer reflektierenden Maske definiert.

## Revendications

1. Procédé de fabrication de dispositif comprenant les étapes de :

   - fournir un substrat (W) qui est au moins partiellement recouvert d'une couche de matériau sensible au rayonnement ;
   - fournir un faisceau de projection (PB) de rayonnement utilisant un système de rayonnement ;
   - utiliser un masque réflecteur (MA) sur lequel un motif est défini par un absorbeur épais pour doter le faisceau de projection dudit motif dans sa section transversale ;
   - projeter le faisceau de rayonnement mis en forme sur une partie cible de la couche de matériau sensible au rayonnement ; et
   - compenser des artefacts d'imagerie causés par des effets d'ombrage dudit absorbeur épais ;

   **caractérisé en ce que** ladite compensation comprend la commande ou la création d'aberrations de système dans le système de projection utilisé dans ladite étape de projection du faisceau mis en forme.

2. Procédé selon la revendication 1 comprenant en outre l'étape de calcul, pour ledit motif, des aberrations optimales à réaliser dans ledit système de projection, ledit calcul tenant compte d'un ou plusieurs paramètres à utiliser dans ladite étape de projection, lesdits paramètres étant sélectionnés parmi le groupe comprenant l'angle d'incidence de masque (MAI), l'épaisseur d'absorbeur, le matériau d'absorbeur, le type de caractéristique et les réglages de NA/éclairage.

3. Procédé selon la revendication 1 ou 2 dans lequel lesdites aberrations de système comprennent un ou plusieurs des polynômes de Zernike Z2 (inclinaison selon X, Z3 (inclinaison selon Y) et Z7 (coma X), où ces polynômes prennent la forme :

Z2:

$$r.cos(\theta)$$

Z3:

$$r.sin(\theta)$$

Z7:

$$(3.r^3-2.r).cos(\theta)$$

4. Procédé selon là revendication 1, 2 ou 3 dans lequel lesdites aberrations sont introduites et/ou commandées de telle sorte que des valeurs d'au moins un paramètre d'imagerie pour différents types de caractéristiques apparaissant dans ledit motif sont rapprochées.

5. Procédé selon la revendication 4 dans lequel ledit au moins un paramètre d'imagerie est sélectionné parmi le groupe comprenant : le décalage de meilleur foyer, l'inclinaison isofocale, la dimension critique, l'uniformité de dimension critique, la superposition, la télécentricité, l'asymétrie de motif, la linéarité de pas et la polarisation iso-dense.

6. Procédé selon la revendication 4 ou 5 dans lequel lesdites différentes caractéristiques ont différentes densités, différentes orientations et/ou différentes dimensions critiques.

7. Procédé selon la revendication 4, 5 ou 6 dans lequel lesdites aberrations sont introduites de manière à rapprocher des fenêtres de traitement pour lesdites différentes caractéristiques.

8. Procédé selon l'une quelconque des revendications précédentes dans lequel lesdites aberrations de système comprennent un ou plusieurs des polynômes de Zernike Z4 (défocalisation), Z5 (astigmatisme HV), Z6 (astigmatisme 45°/135°), Z8 (coma Y), Z9 (aberration sphérique), Z12 (astigmatisme HV - ordre supérieur) et Z13 (astigmatisme 45°/135° - ordre supérieur), où ces polynômes prennent la forme :

Z4:

$$2.r^2-1$$

Z5:

$$r^2.cos(2.\theta)$$

Z6:

$$r^2.sin(2.\theta)$$

Z8:

$$(3.r^3-2.r).\sin(\theta)$$

Z9:

$$6.r^4-6.r^2+1$$

Z12:

$$(4.r^4-3.r^2).\cos(2.\theta)$$

Z13:

$$(4.r^4-3.r^2).\sin(2.\theta)$$

9. Procédé selon la revendication 2 dans lequel l'étape de calcul comprend les étapes de :

déterminer les sensibilités de différentes caractéristiques dans ledit motif vis-à-vis de différentes aberrations ;
déterminer la combinaison optimale d'aberrations en utilisant les sensibilités déterminées.

10. Procédé selon la revendication 9 dans lequel lesdites sensibilités sont déterminées en simulant des images desdites différentes caractéristiques avec différentes quantités et/ou combinaisons d'aberrations.

11. Procédé selon l'une quelconque des revendications précédentes dans lequel ledit absorbeur a une épaisseur supérieure à 50 nm.

12. Procédé informatique pour déterminer des aberrations de système à réaliser dans un système de projection d'un appareil lithographique pour compenser des artefacts d'imagerie causés par un masque, le procédé comprenant d'ordonner à l'ordinateur d'exécuter les étapes de :

déterminer les sensibilités de différentes caractéristiques dans ledit motif vis-à-vis de différentes aberrations ;
déterminer la combinaison optimale d'aberrations en utilisant les sensibilités déterminées ;

**caractérisé en ce que** lesdits artefacts d'imagerie sont causés par des effets d'ombrage d'un absorbeur épais qui définit un motif dans un masque réflecteur.

13. Procédé selon la revendication 12 dans lequel ladite étape de détermination des sensibilités comprend la simulation d'images desdites différentes caractéristiques avec différentes quantités et/ou combinaisons d'aberrations.

14. Procédé selon la revendication 12 ou 13 dans lequel ladite étape de détermination de la combinaison optimale d'aberrations comprend la détermination d'une combinaison d'aberrations à réaliser de telle sorte que des valeurs d'au moins un paramètre d'imagerie pour différents types de caractéristiques apparaissant dans ledit motif sont rapprochées.

15. Procédé selon la revendication 14 dans lequel ledit au moins un paramètre d'imagerie est sélectionné parmi le groupe comprenant : le décalage de meilleur foyer, l'inclinaison isofocale, la dimension critique, l'uniformité de dimension critique, la superposition, la télécentricité, l'asymétrie de motif, la linéarité de pas et la polarisation iso-dense.

16. Procédé selon la revendication 14 ou 15 dans lequel lesdites différentes caractéristiques sont des lignes denses et isolées, et/ou des lignes horizontales et verticales, et/ou des lignes de différentes largeurs.

17. Procédé selon la revendication 14 ou 15 dans lequel ladite étape de détermination de la combinaison optimale d'aberrations comprend la détermination d'une combinaison d'aberrations à réaliser de manière à rapprocher des fenêtres de traitement pour lesdites différentes caractéristiques.

**18.** Procédé selon l'une quelconque des revendications 12 à 17 dans lequel lesdites aberrations de système sont des polynômes de Zernike Z2 (inclinaison selon X), Z3 (inclinaison selon Y) et Z7 (coma X), où ces polynômes prennent la forme :

Z2 :

$$\mathbf{r.cos(\theta)}$$

Z3 :

$$\mathbf{r.sin(\theta)}$$

Z7 :

$$\mathbf{(3.r^3-2.r).cos(\theta)}$$

**19.** Programme informatique comprenant des moyens formant code qui, lorsqu'ils sont exécutés sur un système informatique, ordonnent au système informatique d'exécuter les étapes selon l'une quelconque des revendications 12 à 18.

**20.** Programme informatique comprenant des moyens formant code qui, lorsqu'ils sont exécutés sur un système informatique, ordonnent au système informatique de commander un appareil de projection lithographique en réalisant des aberrations de système dans le système de projection de l'appareil de projection lithographique pour optimiser l'imagerie d'un masque, en compensant des artefacts d'imagerie causés par ledit masque ; **caractérisé en ce que** lesdits artefacts d'imagerie sont causés par des effets d'ombrage d'un absorbeur épais qui définit un motif dans un masque réflecteur.

## Fig. 1

## Fig. 2

**Fig. 3**

Mask Pattern → Calculate Image distortons — S1

↓

Calculate corrective aberations — S2

↓

Calculate mirror position and/or shape changes — S3

↓

Apply calculated changes — S4

↓

Perform imaging — S5

Mask Pattern → CCS

**Fig. 4**

MCS1 — M1 — PL

M2 — MCS2

MA — MT — PM

W — WT — PW

# Fig. 5

Addition of aberration to correct for BFshift due to mask :
starting position - 30nm Bright Field

# Fig. 6

Effect of BFshift correction on IFT :
starting position - 30nm Bright Field

# Fig. 7

**Addition of aberration to correct for BFshift due to mask :**
**Z5-0.26nm and Z9-0.24nm and Z12-0.07nm -30nm Bright Field**

# Fig. 8

**Effect of BFshift correction on IFT :**
**Z5-0.26nm and Z9-0.24nm and Z12-0.07nm - 30nm Bright Field**

## Fig. 9

Addition of aberration to correct for BFshift due to mask :
Z5-0.18nm and Z9-0.22 and Z12-0.18nm - 50nm Bright Field

## Fig. 10

Correction of IFT without impact on BFshifts :
Z5-0.4nm and Z9-0.55nm and Z12-0.11nm - 30nm Bright Field

Fig. 11

**Correction of IFT without impact on BFshift :**
**Z5-0.34nm and Z9-0.11 and Z12-0.37nm - 50nm Bright Field**

Fig. 12

**30nm IL NA/s=0.25/0.5 6 degrees mask incidence**
**Solid-EUV & EUV2D**

## Fig. 13

30nm IL NA/s=0.25/0.5 6 degrees mask incidence
Solid-EUV & EUV2D - TILT CORRECTED

## Fig. 14

30nm IL NA/s=0.25/0.5 0 degrees mask incidence
Solid-EUV & EUV2D

## Fig. 15

30nm IL NA/s=0.25/0.5 0 degrees mask incidence
Solid-EUV & EUV2D - TILT CORRECTED

## Fig. 16

## Fig. 17

## Fig. 18

## Fig. 19

## Fig. 20

## Fig. 21

## Fig. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1251402 A
- EP 1065532 A
- EP 1065568 A
- EP 1260862 A
- EP 1174770 A

**Non-patent literature cited in the description**

- **B. S. BOLLEPALLI ; F. CERRINA.** On the Computation of Reflected Images from Extreme Ultra Violet Masks,. *SPIE Conference on Emerging Lithographic Technologies III,* March 1999, vol. 3676, 587-597
- **C. G. KZAUTSCHIK ; M. ITO ; I. NISHIYAMA ; K. OTAKI.** Impact of the EUV mask phase response on the asymmetry of Bossung curves as predicted by rigorous EUV mask simulations. *SPIE Conference on Emerging Lithographic Technologies V,* March 2001, vol. 4343
- **K OTAKI.** Asymmetric properties of the Aerial Image in Extreme Ultraviolet Lithography. *Jpn. J. Appl. Phys.,* 2000, vol. 39, b819-6826